# EUROPÄISCHE PATENTSCHRIFT

(11) **EP 2 341 763 B1**
(45) Veröffentlichungstag und Bekanntmachung des Hinweises auf die Patenterteilung: **06.03.2019**
(21) Anmeldenummer: 10014655.4
(22) Anmeldetag: 16.11.2010
(51) Int. Cl.: H05K 1/18

(54) **Elektronisches Steuergerät und Verfahren zur Herstellung einer Einheit aus einem Grundkörper und einer Leiterplatte zum Einsatz in einem solchen Steuergerät**
Electronic control device and method for producing a unit comprising a base body and a circuit board for use in such a control device
Appareil de commande électronique et procédé de fabrication d'une unité constituée d'un corps de base et d'une plaquette pour l'insertion dans un tel appareil de commande

(30) Priorität: 22.12.2009 DE 102009060777
(43) Veröffentlichungstag der Anmeldung: 06.07.2011
(73) Patentinhaber: Automotive Lighting Reutlingen GmbH, 72762 Reutlingen (DE)
(72) Erfinder: Johann, Christian, 72770 Reutlingen (DE); Roder, Matthias, 72827 Wannweil (DE); Laubenstein, Rüdiger, 72760 Reutlingen (DE)
(74) Vertreter: DREISS Patentanwälte PartG mbB

(56) Entgegenhaltungen:
- EP-A2- 0 827 372
- WO-A1-93/11654
- DE-A1- 3 936 906
- US-A1- 2003 095 388
- US-A1- 2005 190 531
- US-A1- 2007 212 902

## Beschreibung

Die vorliegende Erfindung betrifft ein elektronisches Steuergerät, insbesondere ein Steuergerät für eine Beleuchtungseinrichtung eines Kraftfahrzeugs. Das Steuergerät umfasst eine mit elektrischen Leiterbahnen versehene und mit elektronischen Bauteilen bestückte Leiterplatte sowie einen mit der Leiterplatte in thermischem Kontakt stehenden Grundkörper aus einem Material mit hoher Wärmeleitfähigkeit. Die Erfindung betrifft außerdem ein Verfahren zur Herstellung einer Einheit aus einem Grundkörper aus einem Material mit hoher thermischer Wärmeleitfähigkeit und einer mit Leiterbahnen versehenen und mit elektronischen Bauteilen bestückten Leiterplatte zum Einsatz in einem Steuergerät, insbesondere in einem Steuergerät für eine Beleuchtungseinrichtung eines Kraftfahrzeugs.

Elektronische Steuergeräte, insbesondere im Kraftfahrzeugbereich, sind zum Schutz vor Verschmutzung, Feuchtigkeit und mechanischen Einwirkungen von außen in einem Steuergerätegehäuse angeordnet. Zur Verbesserung der EMV-Verträglichkeit bestehen diese Gehäuse zumindest teilweise aus Metall. Dabei gibt es häufig einen Zielkonflikt zwischen einer möglichst kleinen Geometrie des Steuergeräts einerseits und der Vermeidung eines Wärmestaus im Inneren des Steuergerätegehäuses andererseits.

Aus verschiedenen Applikationen ist die Verwendung von flexiblen Substraten als Leiterplattenmaterial bekannt.-Eine Leiterplatte dient einerseits als Träger und zur mechanischen Befestigung und andererseits zur elektrischen Kontaktierung von elektronischen Bauteilen. Nahezu jedes elektronische Gerät, insbesondere Steuergerät, enthält eine oder mehrere Leiterplatten. Nach dem derzeitigen Stand der Technik kommen dabei überwiegend starre Leiterplatten zum Einsatz.

Alternativ zu starren Leiterplatten finden in zunehmendem Maße auch dünne flexible Leiterplatten, z.B. auf Basis von Polyimid-Folien, Verwendung. Die damit aufgebauten sog. Flexschaltungen können durch Umformung, bspw. Falten oder Biegen, platzsparend in engste Strukturen z.B. in Fotoapparaten und Videokameras, eingesetzt werden. Nachteilig bei diesen flexiblen Leiterplatten sind jedoch die relativ hohen Kosten, die schlechte Wärmeabfuhr der von den elektrischen Bauteilen während des Betriebs erzeugten Abwärme sowie die fehlende mechanische Formstabilität der Leiterplatte. Dadurch wird die Bestückung der Leiterfolie mit herkömmlichen Bestückungsautomaten erschwert, und die mechanische Stabilisierung der bestückten Leiterplatte, bspw. im Steuergerätegehäuse, erweist sich als sehr aufwendig.

Falls nur ein nicht dauerhaft flexibler Bereich in der Leiterplatte benötigt wird, z.B. um die Montage bei engen Bauraumverhältnissen zu ermöglichen, ist es ferner bekannt, die Materialstärke einer bestückten starren Leiterplatte z.B. durch Fräsen zu verringern. Der verjüngte Bereich kann dann wenige Male gebogen werden. Diese Technik führt zu sog. Starrflex-Leiterplatten. Nachteilig bei dieser Technologie ist allerdings, dass je Biegekante nur eine eindimensionale Verformung möglich ist. Besonders nachteilig bei beengten Platzverhältnissen ist zudem der notwendige relativ große Biegeradius und die damit entfallende Bestückungsfläche in der Biegezone, da eine Bestückung der Leiterplatte nur außerhalb der Biegezone möglich ist.

Schließlich ist zur Vermeidung der Nachteile beim Einsatz von Flexleiterplatten aus dem Stand der Technik ein Aufbau bekannt, bei dem die bestückte flexible Leiterfolie auf einen starren Grundkörper als Träger aufgebracht und z.B. durch Kleben mit diesem verbunden wird. Nachteilig ist hierbei jedoch, dass zur Vermeidung unzulässiger Materialbeanspruchung aufgrund unterschiedlicher Biegeradien das starre Trägermaterial im Knickbereich unterbrochen werden muss. Zur mechanischen Stabilisierung muss dieser Aufbau also mit einem zusätzlichen Konstruktionselement verbunden werden. Außerdem erweist sich auch bei dieser Technologie die Bestückung der flexiblen Leiterplatte aufgrund der fehlenden Formstabilität als aufwendig. Schließlich ist das Aufbringen und Befestigen der bestückten Leiterplatte auf dem Grundkörper aufwendig und kompliziert. Es besteht die Gefahr einer Zerstörung der elektrischen Bauteile oder eines Lösens der Bauteile von der Leiterplatte während des Befestigungsvorgangs.

Bei elektronischen Steuergeräten ist es auf Grund thermischer Anforderungen und Gegebenheiten meist erforderlich, die elektrischen Komponenten (Bauteile) in geeigneter Weise zu kühlen. Dies kann bspw. durch mechanische Anbindung an einen Kühlkörper erfolgen, über den die Wärme abtransportiert und an die Umgebung abgegeben werden kann.

EP 0 827 372 offenbart eine mit elektronischen Bauteilen bestückte Leiterplatte, die ein flexibles Substrat umfasst, welches mit einem Grundkörper aus einem Material mit hoher Wärmeleitfähigkeit in Kontakt steht. Der Grundkörper verfügt über eine längliche Einkerbung, die sich über die gesamte Breite des Grundkörpers erstreckt und das Substrat hat zwei Schlitze, die sich quer zur Einkerbung im Grundkörper erstrecken.

Ausgehend von dem beschriebenen Stand der Technik liegt der vorliegenden Erfindung die Aufgabe zugrunde, eine Verbesserung der Herstellung einer Einheit aus Leiterplatte und Grundkörper für ein Steuergerät vorzuschlagen, durch welche die Nachteile des Standes der Technik vermieden werden. Insbesondere soll die vorliegende Erfindung eine optimale Anbindung wärmeabgebender Bauteile an einen Kühlkörper bei Verwendung von flexiblen Leiterplatten ermöglichen. Ein weiteres Ziel ist eine optimale Ausnutzung des zur Verfügung stehenden Volumens und der Leiterplattenoberfläche für die Platzierung von elektrischen und elektronischen Komponenten im Steuergerät bei gleichzeitiger Verbesserung der Wärmeabfuhr von Aufbauten und dreidimensional geformten flexiblen Leiterplatten. Schließlich soll die für die elektronischen Komponenten zur Verfügung stehende Fläche möglichst groß sein und während der Bestückung sowie während der Verwendung des Steuergeräts eine hinreichende Festigkeit für oberflächenmontierte Bauelemente bestehen.

Die Erfindung wird in den beigefügten Ansprüchen definiert.

Mit der vorliegenden Erfindung sind komplexe dreidimensionale Leiterplattenformen in elektronischen Steuergeräten realisierbar. Dabei werden die Nachteile des Standes der Technik von mit flexiblen Leiterplatten realisierten Aufbauten wie schlechte Wärmeabfuhr, geringe Formstabilität und schwierige Bestückung mit herkömmlichen Bestückungsautomaten vermieden. Gleichzeitig werden jedoch die Vorteile flexibler Leiterplatten wie hohe Zuverlässigkeit bei hohen Temperaturen und dreidimensionale Formbarkeit beibehalten. Der Grundkörper besteht aus einem Material mit hoher Wärmeleitfähigkeit, wie bspw. Metall, und bildet gleichzeitig einen Kühlkörper, über den die Abwärme abgeführt werden kann.

Durch das Aufbringen des Substrats auf eine Abwicklung des Grundkörpers sind verschiedene Vorteile verbunden. Zunächst kann eine optimale thermische Anbindung des Substrats an den Grundkörper sichergestellt werden. Das Aufbringen des Substrats auf den Grundkörper erfolgt bspw. mittels einer Klebeverbindung. Selbstverständlich kann das Aufbringen auch auf beliebig andere geeignete Weise erfolgen. Wichtig bei der Wahl eines geeigneten Verfahrens zum Aufbringen des Substrats auf den Grundkörper ist dabei insbesondere, dass eine gute thermische Anbindung des Substrats bzw. der elektrischen und elektronischen Komponenten (Bauteile) des Steuergeräts an den Grundkörper gewährleistet wird. Bei der Befestigung des Substrats auf dem Grundkörper können zudem Anpresskräfte auf das Substrat bzw. den Grundkörper aufgebracht werden, ohne die Gefahr, dass bereits bestückte Bauteile dadurch beschädigt werden könnten, da das Substrat erst danach mit den Bauteilen bestückt wird. Es wird also vermieden, dass die zur Fixierung der Leiterplatte auf dem Grundkörper erforderlichen Anpresskräfte über die elektrischen Bauteile aufgebracht werden müssen.

Zwischen der Leiterplatte und dem Grundkörper besteht vorteilhafterweise nicht nur eine thermische Anbindung, sondern auch eine elektrische Anbindung, vorzugsweise auf Massepotential. Dadurch wird das EMV-Verhalten der Grundkörper-Substrat-Einheit verbessert. Außerdem könnte durch eine geeignete elektrische Anbindung eine Lage der flexiblen Leiterplatte eingespart werden. Vorzugsweise wird die Leiterplatte mit zwei Signallagen und einer Masselage (Unterseite) ausgeführt. Die Masselage könnte ohne isolierende Schutzschicht (z.B. Lötstopplack) ausgeführt und mit einem elektrisch leitfähigen Kleber oder auf andere Weises auf den Grundkörper aufgebracht werden. Damit wäre das Gehäuse bezüglich EMV bestmöglich an Masse angebunden. Falls als Masselage der metallische Grundkörper verwendet wird, kann die Masselage in der flexiblen Leiterplatte entfallen. Dazu müssten die Schaltungsnetze mit Massepotential von der flexiblen Leiterplatte kommend in geeigneter Weise mit dem Grundkörper verbunden werden. Dies könnte bspw. durch einen elektrisch leitfähigen Kleber, der an den betreffenden Stellen aufgebracht wird, erfolgen. Die Netze mit sonstigen Potentialen müssten auf der flexiblen Leiterplatte zum Grundkörper hin isoliert werden.

Ein weiterer Vorteil besteht in der hinreichenden Festigkeit der Substrat-Grundkörper-Einheit zur Montage der SMD (Surface Mounted Device)-Bauteile mit herkömmlichen Bestückungsautomaten sowie nach dem Einbringen der bestückten Substrat-Grundkörper-Einheit in ein Steuergerätegehäuse. Auf zusätzliche Konstruktionselemente zur Stabilisierung der Leiterplatte im Inneren des Steuergerätegehäuses kann aufgrund der hohen Formstabilität der fertig bestückten und in einer gewünschten Weise umgeformten Substrat-Grundkörper-Einheit verzichtet werden.

Vorzugsweise stellt die Abwicklung des Grundkörpers ein zusammenhängendes Gebilde dar, das insbesondere im Bereich der Biegezonen ohne Schlitze ausgebildet ist. Das ist für die Dichtigkeit des Gebildes gegenüber Umwelteinflüssen (Schmutz, Feuchtigkeit) und elektromagnetischer Strahlung von großem Vorteil, insbesondere wenn der Grundkörper als Teil des Steuergerätegehäuses eingesetzt werden soll oder das Steuergerätegehäuse selbst bildet. Außerdem kann dadurch ein guter thermischer Übergang zwischen den Teilflächen gewährleistet werden.

Weitere Merkmale und Vorteile der Erfindung werden nachfolgend anhand von bevorzugten Ausführungsbeispielen unter Bezugnahme auf die Figuren näher erläutert. Dabei werden funktionsäquivalente Bauteile mit den gleichen Bezugszeichen bezeichnet. Es zeigen:
- Figur 1: eine Beleuchtungseinrichtung für ein Kraftfahrzeug in einer perspektivischen Ansicht;
- Figur 2: eine Abwicklung eines Grundkörpers mit darauf aufgebrachter Leiterplatte eines erfindungsgemäßen Steuergeräts gemäß einer bevorzugten Ausführungsform in einer Draufsicht;
- Figur 3: die Abwicklung des Grundkörpers mit der darauf aufgebrachten Leiterplatte aus Figur 2 in einer Seitenansicht;
- Figur 4: den Grundkörper mit der darauf aufgebrachten Leiterplatte aus den Figuren 2 und 3 nach dem Umformen in einer Seitenansicht;
- Figur 5: eine Abwicklung eines Grundkörpers mit darauf aufgebrachter Leiterplatte eines erfindungsgemäßen Steuergeräts gemäß einer weiteren bevorzugten Ausführungsform in einer Seitenansicht;
- Figur 6: den Grundkörper mit der darauf aufgebrachten Leiterplatte aus Figuren 5 nach dem Umformen in einer Seitenansicht;
- Figur 7: eine Abwicklung eines Grundkörpers mit darauf aufgebrachter Leiterplatte eines erfindungsgemäßen Steuergeräts gemäß noch einer weiteren bevorzugten Ausführungsform in einer Seitenansicht; und
- Figur 8: den Grundkörper mit der darauf aufgebrachten Leiterplatte aus Figuren 7 während des Umformvorgangs in einer Seitenansicht.

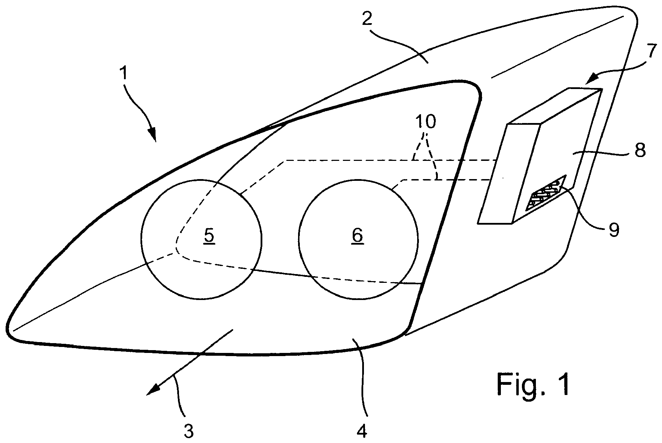

In Figur 1 ist eine Beleuchtungseinrichtung für ein Kraftfahrzeug in ihrer Gesamtheit mit dem Bezugszeichen 1 bezeichnet. Die Beleuchtungseinrichtung 1 ist in dem dargestellten Ausführungsbeispiel als ein Frontscheinwerfer ausgebildet. Selbstverständlich kann sie jedoch auch als eine Leuchte, insbesondere als eine Heckleuchte, ausgebildet sein. Der Scheinwerfer 1 umfasst ein Gehäuse 2, das vorzugsweise aus Kunststoff besteht. Das Gehäuse 2 weist in Lichtaustrittsrichtung 3 eine Lichtaustrittsöffnung auf, die durch eine transparente Abdeckscheibe 4 verschlossen ist. Die Abdeckscheibe 4 kann ohne optisch wirksame Elemente (z.B. Prismen, etc.) ausgebildet sein (sog. klare Scheibe). Es ist aber auch denkbar, dass die Scheibe 4 zumindest teilweise mit optisch wirksamen Elementen ausgestattet ist, bspw. um eine Streuung des durch die Scheibe 4 hindurchtretenden Lichts in horizontaler Richtung zu bewirken. Bei einem Scheinwerfer ist die Scheibe 4 vorzugsweise farblos ausgestaltet. Bei einer Rückleuchte kann die Scheibe 4 eingefärbt sein, insbesondere rot für eine Leuchte für Rücklicht, Bremslicht oder Nebelschlusslicht und/oder gelb für eine Blinkleuchte.

Im Inneren des Scheinwerfergehäuses 2 sind zwei Lichtmodule 5, 6 angeordnet, die zur Erzeugung einer bestimmten Lichtverteilung ausgebildet sind. Bei einem Scheinwerfer können die Lichtmodule 5, 6 als Reflexionsmodule und/oder als Projektionsmodule ausgebildet sein. Ein Reflexionsmodul umfasst mindestens eine Lichtquelle zum Aussenden von Licht und einen Reflektor, der das ausgesandte Licht zur Erzeugung der gewünschten Lichtverteilung auf die Fahrbahn vor das Kraftfahrzeug reflektiert. Ein Projektionsmodul umfasst mindestens eine Lichtquelle, eine Primäroptik (z.B. einen Reflektor oder eine Vorsatzoptik) zum Bündeln des ausgesandten Lichts und eine Sekundäroptik (z.B. eine Projektionslinse) zur Projektion des gebündelten Lichts auf die Fahrbahn vor das Kraftfahrzeug, um die gewünschte Lichtverteilung zu erzeugen. Falls die gewünschte Lichtverteilung eine Helldunkelgrenze aufweist, umfasst das Projektionsmodul zusätzlich noch eine zwischen Reflektor und Linse angeordnete Blendenanordnung, deren Oberkante von der Sekundäroptik als Helldunkelgrenze auf die Fahrbahn projiziert wird. Selbstverständlich können die Lichtmodule, insbesondere wenn die Beleuchtungseinrichtung 1 als eine Leuchte ausgebildet ist, auch Lichtleiter und/oder andere optische Elemente aufweisen. Es ist denkbar, dass die Beleuchtungseinrichtung 1 weniger oder mehr als die dargestellten zwei Lichtmodule 5, 6 aufweist.

Die Lichtmodule 5, 6 des Scheinwerfers 1 aus Figur 1 können bspw. eine Abblendlicht-, Fernlicht-, Nebellicht-, Tagfahrlicht-, Positionslicht-, Standlicht-, Blinklicht-, Stadtlicht-, Landstraßenlicht-, Autobahnlicht-, statische oder dynamische Kurvenlicht- oder eine beliebig andere statische oder adaptive Lichtverteilung erzeugen. Die Lichtmodule 5, 6 können die gewünschte Lichtverteilung alleine oder im Zusammenwirken miteinander oder mit anderen, nicht gezeigten Lichtmodulen des Scheinwerfers 1 erzeugen. Bei einer als Heckleuchte ausgebildeten Beleuchtungseinrichtung 1 können die Lichtmodule eine Rücklicht-, Bremslicht-, Nebelschlusslicht-, Blinklicht-, Rückfahrlicht- oder eine beliebig andere Lichtverteilung erzeugen.

Außen an dem Gehäuse 2 der Beleuchtungseinrichtung 1 ist ein Steuergerät 7 angeordnet, das ein Gehäuse 8 aufweist, das vorzugsweise aus Metall, insbesondere Aluminiumdruckguss, besteht. Das Steuergerätegehäuse 8 umfasst einen Stecker oder eine Buchse 9, über die das Steuergerät 7 an eine Energieversorgung, bspw. eine Spannung einer Fahrzeugbatterie, und/oder an ein übergeordnetes Steuergerät (Body Controller) angeschlossen ist. Das Steuergerätegehäuse 8 ist auf einer Öffnung (nicht dargestellt) im Scheinwerfergehäuse 2 angeordnet, durch die Leitungen 10 vom Steuergerät 7 zu den Lichtmodulen 5, 6 hindurchgeführt sind. Um ein Eindringen von Feuchtigkeit und Schmutz in das Innere des Scheinwerfergehäuses 2 zu verhindern, ist das Steuergerätegehäuse 8 gegenüber dem Scheinwerfergehäuse 2 abgedichtet, bspw. mittels geeigneter Dichtmittel, insbesondere mittels einer um die Öffnung verlaufenden Dichtlippe aus elastischem Material. Selbstverständlich kann das Steuergerät 8 auch an einer anderen als der in Figur 1 gezeigten Stelle außen am Scheinwerfer 1 angeordnet sein. Außerdem ist es denkbar, dass das Steuergerät 8 nicht außen, sondern innen am Gehäuse 2 oder an einer beliebig anderen Stelle separat vom Scheinwerfergehäuse 2 angeordnet ist.

Im Inneren des Gehäuses 8 sind auf einer oder mehreren Leiterplatten elektronische Bauteile angeordnet und mittels Leiterbahnen derart miteinander verschaltet, dass das Steuergerät 7 eine gewünschte Steuerungs- und/oder Regelungsfunktion im Zusammenhang mit dem Betrieb der Beleuchtungseinrichtung 1 erfüllen kann. Die elektronischen Bauteile erzeugen während des Betriebs des Steuergeräts 7 Abwärme, die aus dem Inneren des Gehäuses 8 nach außen abgeführt werden muss, um einen Hitzestau und eine Beschädigung oder Funktionsstörung der elektronischen Bauteile zu vermeiden. Gleichzeitig soll das Steuergerät 7 möglichst kleinbauend und leicht ausgebildet sein. Dies wird durch das erfindungsgemäße Steuergerät 7 ermöglicht. Dabei ist im Inneren des Gehäuses 8 eine Leiterplatte in Form eines flexiblen Substrats angeordnet, das vor der Bestückung mit den elektronischen Bauteilen auf eine Abwicklung eines Grundkörpers aufgebracht wird. Anschließend erfolgt dann eine Umformung der bestückten Grundkörper-Substrat-Einheit in eine gewünschte Geometrie. Auf diese Weise kann die Grundkörper-Substrat-Einheit so geformt werden, dass sie den Innenraum des Gehäuses 8 möglichst effizient ausnutzt.

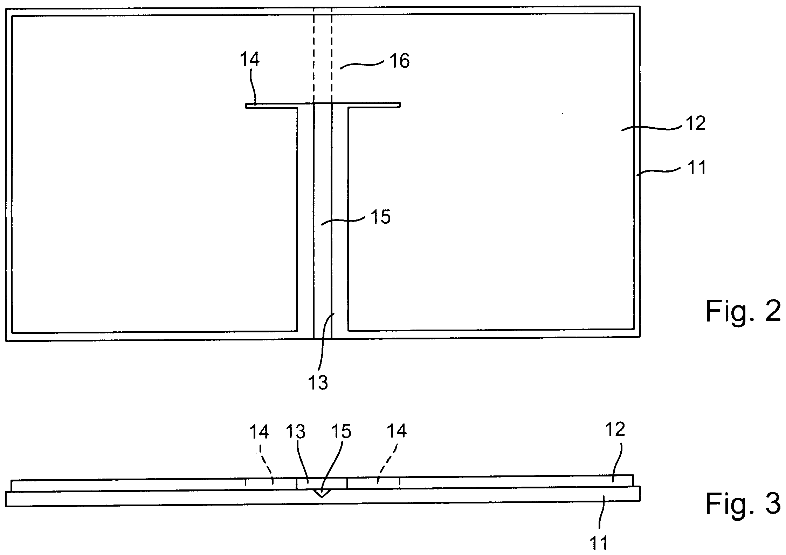

In den Figuren 2 und 3 ist eine Abwicklung eines Grundkörpers in ihrer Gesamtheit mit dem Bezugszeichen 11 bezeichnet. Der Grundkörper 11 weist eine im wesentlichen rechteckige Form ohne Schlitze und Einschnitte auf. Er besteht aus einem Material, das elektromagnetische Strahlung gut abschirmen kann, bspw. Metall. Außerdem weist das Material des Grundkörpers 11 eine gute thermische Wärmeleitfähigkeit auf. Der Grundkörper 11 dient zur mechanischen Stabilisierung und Kühlung der flexiblen Leiterplatte 12 sowie zur Verbesserung der EMV-Verträglichkeit des Steuergeräts 7. Der Grundkörper 11 ist biegbar, damit die Grundkörper-Substrat-Einheit 11, 12 nach der Bestückung mit den elektronischen Bauteilen in die gewünschte Form gebracht werden kann. Es ist denkbar, dass der umgeformte Grundkörper 11 einen Teil des Steuergerätegehäuses 8, bspw. einen abnehmbaren Deckel des Gehäuses 8, bildet. Dabei ist der Grundkörper 11 vorzugsweise mittels eines geeigneten Dichtmittels zum restlichen Steuergerätegehäuse 8 abgedichtet. Selbstverständlich kann der Grundkörper 11 auch das gesamte Steuergerätegehäuse 8 bilden.

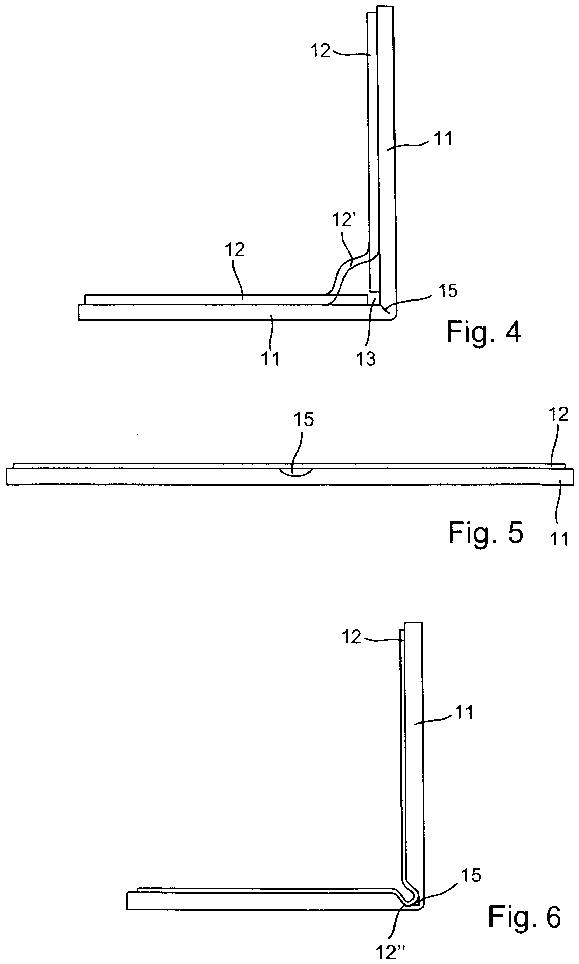

Die flexible Leiterplatte 12 wird vor der Bestückung mit elektronischen Bauelementen auf den Grundkörper 11 aufgebracht und darauf befestigt, bspw. mittels Klebstoff. Das auf den Grundkörper 11 aufgebrachte Substrat 12 weist etwa in der Mitte einen T-förmigen Einschnitt 13 auf, wobei die Querbalken des T-förmigen Einschnitts 13 als schmale Schlitze 14 ausgebildet sind. Außerdem verfügt der Grundkörper 11 über eine längliche Einkerbung 15, die sich im Bereich des Einschnitts 13 über die gesamte Breite des Grundkörpers 11 erstreckt. Die Einkerbung 15 kann auf der Außenseite und/oder der Innenseite des Grundkörpers 11 ausgebildet sein. Die Einkerbung 15 hat eine im Querschnitt dreieckige Form. Selbstverständlich kann die Einkerbung 15 auch eine beliebig andere Form, bspw. die Form eines Kreissegments, haben (vgl. Figur 5). Nach der Befestigung des Substrats 12 auf dem Grundkörper 11 erfolgt die Bestückung der Leiterplatte 12 mit den elektronischen Bauteilen mittels eine herkömmlichen Bestückungsautomaten. Durch die Stabilisierung der flexiblen Leiterplatte 12 durch den Grundkörper 11 weist die Leiterplatte 12 die für die automatische Bestückung erforderliche Formstabilität auf.

Es ist denkbar, dass das Substrat 12 nicht auf der gesamten Fläche auf dem Grundkörper 11 befestigt ist. So kann das Substrat 12 in einem Bereich 16 oberhalb der Einkerbung 15 und daneben nicht auf dem Grundkörper 11 befestigt sein. Wenn die Grundkörper-Substrat-Einheit 11, 12 entlang der Kerbe 15 nach Innen umgeformt wird (vgl. Figur 4), kann sich das Substrat 12 im Bereich 16 oberhalb der Kerbe 15 und daneben vom Grundkörper 11 lösen. Dadurch kann das Substrat 12 in einem größeren Radius dem Verlauf des Grundkörpers 11 im Umformbereich folgen, wobei eine Beschädigung des Substrats 12 im Umformbereich verhindert wird. Die Geometrie der Leiterplatte 12 und des Trägers 11 ist so gewählt, dass eine Biegung mit geringem Radius bei gleichzeitiger Einhaltung der mechanischen Belastbarkeit der Komponenten gewährleistet ist. Im Knickbereich 15 ist also die Leiterplatte 12 unterbrochen. Gleichzeitig wird durch die im Knickbereich 15 und daneben nicht am Grundkörper 11 befestigte Leiterplatte 12 ein dedizierter Übergangsbereich 12' mit vergrößertem Biegeradius gebildet, wobei ein Teil der Biegung des Leitermaterials 12 der Biegung des Trägermaterials 11 entgegengesetzt sein kann. Die Leitermaterialbiegung ist dabei so ausgestaltet, dass die zulässigen Biegeradien eingehalten werden. Von der Leiterplatte 12' im Knickbereich 15 wird also ein geringer Teil des von den beiden Seiten des Grundkörpers 11 aufgespannten Raums beansprucht. Das ist allerdings unproblematisch, da die Leiterplatte 12' flexibel ist und in die gewünschte Form und Position gebracht werden kann, wo sie die übrigen Bauelemente nicht behindert.

Die Umformung in die gewünschte Geometrie erfolgt nach der Bestückung der elektronischen Komponenten. Durch geeignete Wahl des Substrats 12 (Aufbau, Material, Geometrie, etc.) und ein geeignetes Design des Grundkörpers 11 (geringere Materialstärke im Bereich der Biegezonen 15, auf der Außenseite oder der Innenseite des Körpers 11) sowie der Biegeparameter (Radius, Biegekräfte, etc.) kann die Abwicklung 11 in die gewünschte Form gebracht werden. Die Einkerbung 15 im Umformbereich 16 dient der Verbesserung der Verformbarkeit des Trägermaterials 11. Dabei sollte die Einkerbung 15 nur so tief sein, dass noch eine ausreichende Restfestigkeit des restlichen Trägermaterials 11 verbleibt. Alternativ kann durch günstige Formgebung des Trägermaterials 11 im Knickbereich 15 auch die mechanische Belastung des Leitermaterials 12 verringert werden.

Die Ausführungsform aus Figur 5 unterschiedet sich von der aus den Figuren 2 bis 4 insbesondere in der Form und den Abmessungen der Einkerbung 15. Diese ist kreissegmentbspw. halbkreisförmig ausgebildet. Außerdem ist die flexible Leiterplatte 12 auch unmittelbar neben der Einkerbung 15 auf dem Grundkörper 11 befestigt, bspw. mittels Klebstoff. Beim Umformen des Grundkörpers 11 entlang der Einkerbung 15 erstreckt sich der ursprünglich oberhalb der Einkerbung 15 befindliche Teil 12" der Leiterplatte 12 in die Einkerbung 15 hinein (vgl. Figur 6). Wenn vor dem Umformen Klebstoff in die Einkerbung 15 eingebracht worden ist, wird die Leiterplatte 12" in der umgebogenen Position des Grundkörpers 11 sogar in der Einkerbung 15 festgeklebt, wodurch die umgeformte Grundkörper-Substrat-Einheit 11, 12 zusätzliche Stabilität erhält. Zudem wird von der Leiterplatte 12 im Knickbereich 15 kein zusätzlicher Raum in dem von den beiden Seiten des Grundkörpers 11 aufgespannten Raum benötigt. Vielmehr ist die Leiterplatte 12" im Knickbereich von der Einkerbung 15 aufgenommen.

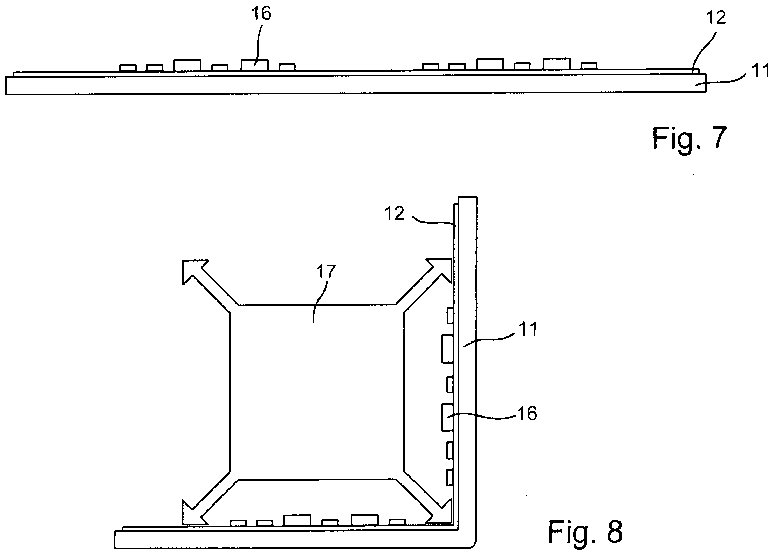

Anhand der Figuren 7 und 8 wird ein bevorzugtes Ausführungsbeispiel zum Umformen der mit elektronischen Bauteilen 16 bestückten Grundkörper-Substrat-Einheit 11, 12 erläutert. Es wird vorgeschlagen, das Trägermaterial 11 mit darauf befestigter, bspw. aufgeklebter Leiterfolie 12 mit den bestückten elektronischen Bauteilen 16 um einen Umformungskörper 17 zu biegen. Hierdurch kann eine unzulässige Verformung des Leitermaterials 12 sowie eine Beschädigung der Bauteile 16 verhindert werden.

## Patentansprüche

1. Elektronisches Steuergerät (7), insbesondere Steuergerät (7) für eine Beleuchtungseinrichtung (1) eines Kraftfahrzeugs, umfassend eine mit elektrischen Leiterbahnen versehene und mit elektronischen Bauteilen (16) bestückte Leiterplatte (12), die ein flexibles Substrat umfasst, sowie einen mit der Leiterplatte (12) in Kontakt stehenden Grundkörper (11) aus einem Material mit hoher Wärmeleitfähigkeit, wobei das flexible Substrat (12) vor der Bestückung mit den elektronischen Bauteilen (16) auf einer Abwicklung des Grundkörpers (11) befestigt ist und eine Umformung der Grundkörper-Substrat-Einheit (11, 12) in eine gewünschte Geometrie nach der Bestückung der Grundkörper-Substrat-Einheit (11, 12) mit den elektronischen Bauteilen (16) erfolgt,
wobei zwischen dem Grundkörper (11) und dem darauf befestigten flexiblen Substrat (12) Verbindungsmittel eingebracht sind, die sowohl eine thermische Anbindung als auch eine elektrische Anbindung zwischen dem Grundkörper (11) und dem flexiblen Substrat (12) bewirken, und dass das flexible Substrat (12) einen T-förmigen Einschnitt (13) aufweist, wobei der Grundkörper (11) über eine längliche Einkerbung (15) verfügt, die sich im Bereich des Einschnitts (13) über die gesamte Breite des Grundkörpers (11) erstreckt, wobei der Längsbalken des T-förmigen Einschnitts (13) sich längs der Einkerbung (15) des Grundkörpers (11) erstreckt, und der Querbalken des T-förmigen Einschnitts (13) als ein schmaler Schlitz (14) angeordnet ist, der sich senkrecht zu der Einkerbung (15) erstreckt.

2. Steuergerät (7) nach Anspruch 1, **dadurch gekennzeichnet, dass** zwischen dem flexiblen Substrat (12) und dem Grundkörper (11) eine elektrische Anbindung auf Massepotential besteht.

3. Steuergerät (7) nach Anspruch 1 oder 2, **dadurch gekennzeichnet, dass** das Substrat (12) mittels einer Klebeverbindung auf die Abwicklung des Grundkörpers (11) aufgebracht ist.

4. Steuergerät (7) nach einem der Ansprüche 1 bis 3, **dadurch gekennzeichnet, dass** die Abwicklung des Grundkörpers (11) spaltfrei ausgebildet ist.

5. Steuergerät (7) nach einem der Ansprüche 1 bis 4, **dadurch gekennzeichnet, dass** der Grundkörper (11) der umgeformten Grundkörper-Substrat-Einheit (11, 12) zumindest einen Teil eines Steuergerätegehäuses (8) bildet.

6. Steuergerät (7) nach einem der Ansprüche 1 bis 5, **dadurch gekennzeichnet, dass** das Substrat (12) im Bereich der Einkerbung (15) zumindest teilweise unterbrochen ist.

7. Steuergerät (7) nach einem der Ansprüche 1 bis 6, **dadurch gekennzeichnet, dass** das Substrat (12) im Bereich (16) der Einkerbung (15) einen größeren Biegeradius aufweist als der Grundkörper (11).

8. Verfahren zur Herstellung einer Einheit aus einem Grundkörper (11) aus einem Material mit hoher thermischer Wärmeleitfähigkeit und einer mit Leiterbahnen versehenen und mit elektronischen Bauteilen (16) bestückten Leiterplatte (12), die ein flexibles Substrat umfasst und mit dem Grundkörper (11) in Kontakt steht, zum Einsatz in einem elektronischen Steuergerät (7), insbesondere in einem Steuergerät (7) für eine Beleuchtungseinrichtung (1) eines Kraftfahrzeugs, wobei das flexible Substrat (12) vor der Bestückung mit den elektronischen Bauteilen (16) auf einer Abwicklung des Grundkörpers (11) befestigt wird und die Grundkörper-Substrat-Einheit (11, 12) nach der Bestückung der Grundkörper-Substrat-Einheit (11, 12) mit den elektronischen Bauteilen (16) in eine gewünschte Geometrie umgeformt wird, wobei das flexible Substrat (12) derart auf dem Grundkörper (11) befestigt wird, dass zwischen dem Grundkörper (11) und dem Substrat (12) sowohl eine thermische Anbindung als auch eine elektrische Anbindung besteht, und dass in das flexible Substrat (12) ein T-förmiger Einschnitt (13) eingebracht wird, wobei in den Grundkörper (11) eine längliche Einkerbung (15) eingebracht wird, die sich im Bereich des Einschnitts (13) über die gesamte Breite des Grundkörpers (11) erstreckt, wobei der Längsbalken des T-förmigen Einschnitts (13) sich längs der Einkerbung (15) des Grundkörpers (11) erstreckt, und der Querbalken des T-förmigen Einschnitts (13) als ein schmaler Schlitz (14) angeordnet ist, der sich senkrecht zu der Einkerbung (15) erstreckt.

9. Verfahren nach Anspruch 8, **dadurch gekennzeichnet, dass** zum Umformen der Grundkörper-Substrat-Einheit (11, 12) in die gewünschte Geometrie ein Umformungsgrundkörper (17) verwendet wird, um den die Grundkörper-Substrat-Einheit (11, 12) gebogen wird.

## Claims

1. Electronic control unit (7), in particular control unit (7) for a lighting device (1) of a motor vehicle, comprising a printed circuit board (12) which is provided with electrical conductor tracks, and which is fitted with electronic components (16) and comprises a flexible substrate, and a base body (11) which is in contact with the printed circuit board (12) and is made of a material having a high thermal conductivity, wherein the flexible substrate (12) is fastened to a flat projection of the base body (11) prior to being fitted with the electronic components (16), and the base body-substrate unit (11, 12) is formed into a desired geometry after the base body-substrate unit (11, 12) has been fitted with the electronic components (16), wherein connecting means are introduced between the base body (11) and the flexible substrate (12) fastened thereto, which connecting means effect both a thermal connection and an electrical connection between the base body (11) and the flexible substrate (12), and that the flexible substrate (12) has a T-shaped incision (13), wherein the base body (11) has an elongate notch (15), the longitudinal beam of the T-shaped incision (13) extending along the notch (15) of the base body (11) and the transverse beam of the T-shaped incision (13) being arranged as a narrow slot (14) extending perpendicularly to the notch (15).

2. Control device (7) according to claim 1, **characterized in that** an electrical connection to ground potential exists between the flexible substrate (12) and the base body (11).

3. Control unit (7) according to claim 1 or 2, **characterized in that** the substrate (12) is applied to the flat projection of the base body (11) by means of an adhesive connection.

4. Control unit (7) according to one of claims 1 to 3, **characterized in that** the development of the base body (11) is designed to be gap-free.

5. Control unit (7) according to one of claims 1 to 4, **characterized in that** the base body (11) of the formed base body-substrate unit (11, 12) forms at least a part of a control unit housing (8).

6. Control device (7) according to one of claims 1 to 5, **characterized in that** the substrate (12) is at least partially interrupted in the region of the notch (15).

7. Control unit (7) according to one of claims 1 to 6, **characterized in that** the substrate (12) has a larger bending radius in the region (16) of the notch (15) than the base body (11) .

8. Method for producing a unit comprising a base body (11) made of a material with high thermal conductivity and a printed circuit board (12) which is provided with conductive tracks and fitted with electronic components (16), comprises a flexible substrate and is in contact with the base body (11), for use in an electronic control unit (7), in particular in a control unit (7) for a lighting device (1) of a motor vehicle, the flexible substrate (12) being fastened to a flat projection of the base body (11) before being fitted with the electronic components (16), and the base body-substrate unit (11, 12) being formed into a desired geometry after being fitted with the electronic components (16) to the base body-substrate unit (11, 12), in that the flexible substrate (12) is fastened to the base body (11) in such a way that both a thermal connection and an electrical connection exist between the base body (11) and the substrate (12), and in that a T-shaped incision (13) is made in the flexible substrate (12), an elongate notch (15) being made in the base body (11), the longitudinal beam of the T-shaped incision (13) extending along the notch (15) of the base body (11) and the transverse beam of the T-shaped incision (13) being arranged as a narrow slot (14) extending perpendicularly to the notch (15).

9. A method according to claim 8, **characterized in that** for forming the body-substrate unit (11, 12) into the desired geometry, a forming body (17) is used about which the body-substrate unit (11, 12) is bent.

## Revendications

1. Appareil de commande (7) électronique, en particulier appareil de commande (7) pour un dispositif d'éclairage (1) d'un véhicule à moteur, comportant une carte de circuits imprimés (12) pourvue de tracés conducteurs électriques et sur laquelle sont implantés des composants électroniques (16), laquelle carte comporte un substrat flexible, l'appareil comportant également un corps de base (11) en contact avec la carte de circuits imprimés (12) et composé d'un matériau présentant une conductibilité thermique élevée, dans lequel le substrat flexible (12), avant l'implantation des composants électroniques (16), est fixé sur une partie déroulée du corps de base (11) et il s'effectue une mise en forme de l'unité corps de base-substrat (11, 12) selon une géométrie souhaitée après l'implantation des composants électroniques (16) sur l'unité corps de base-substrat (11, 12), dans lequel des moyens de liaison sont introduits entre le corps de base (11) et le substrat flexible (12) fixé sur celui-ci, lesquels réalisent aussi bien un raccordement thermique qu'un raccordement électrique entre le corps de base (11) et le substrat flexible (12), et en ce que le substrat flexible (12) présente une entaille en forme de T (13), dans lequel le corps de base (11) dispose d'une encoche (15) allongée, qui s'étend dans la zone de l'entaille (13) sur toute la largeur du corps de base (11), dans lequel la barre longitudinale de l'entaille en forme de T (13) s'étend le long de l'encoche (15) du corps de base (11), et la barre transversale de l'entaille en forme de T (13) est réalisée sous la forme d'une fente (14) étroite qui s'étend perpendiculairement à l'encoche (15).

2. Appareil de commande (7) selon la revendication 1, **caractérisé en ce qu'**un raccordement électrique à la masse est présent entre le substrat flexible (12) et le corps de base (11) .

3. Appareil de commande (7) selon la revendication 1 ou 2, **caractérisé en ce que** le substrat (12) est appliqué sur la partie déroulée du corps de base (11) au moyen d'une liaison adhésive.

4. Appareil de commande (7) selon l'une quelconque des revendications 1 à 3, **caractérisé en ce que** la partie déroulée du corps de base (11) est réalisée sans laisser de fente.

5. Appareil de commande (7) selon l'une quelconque des revendications 1 à 4, **caractérisé en ce que** le corps de base (11) de l'unité corps de base-substrat (11, 12) mise en forme constitue au moins une partie d'un boîtier d'appareil de commande (8).

6. Appareil de commande (7) selon l'une quelconque des revendications 1 à 5, **caractérisé en ce que** le substrat (12) est interrompu au moins en partie dans la zone de l'encoche (15) .

7. Appareil de commande (7) selon l'une quelconque des revendications 1 à 6, **caractérisé en ce que** le substrat (12) présente dans la zone (16) de l'encoche (15) un rayon de courbure supérieur à celui du corps de base (11).

8. Procédé de fabrication d'une unité composée d'un corps de base (11) constitué d'un matériau présentant une conductibilité thermique élevée et d'une carte de circuits imprimés (12) pourvue de tracés conducteurs et sur laquelle sont implantés des composants électroniques (16), laquelle carte comporte un substrat flexible et est en contact avec le corps de base (11), ladite unité étant destinée à être utilisée dans un appareil de commande électronique (7), en particulier dans une appareil de commande (7) pour un dispositif d'éclairage (1) d'un véhicule à moteur, dans lequel le substrat flexible (12), avant l'implantation des composants électroniques (16), est fixé sur une partie déroulée du corps de base (11) et l'unité corps de base-substrat (11, 12) est mise en forme selon une géométrie souhaitée après l'implantation des composants électroniques (16) sur l'unité corps de base-substrat (11, 12), dans lequel le substrat flexible (12) est fixé au corps de base (11) de telle sorte qu'aussi bien un raccordement thermique qu'un raccordement électrique est présent entre le corps de base (11) et le substrat flexible (12), et en ce qu'une entaille en forme de T (13) est ménagée dans le substrat flexible (12), dans lequel une encoche (15) allongée, qui s'étend dans la zone de l'entaille (13) sur toute la largeur du corps de base (11), est ménagée dans le corps de base (11), dans lequel la barre longitudinale de l'entaille en forme de T (13) s'étend le long de l'encoche (15) du corps de base (11), et la barre transversale de l'entaille en forme de T (13) est réalisée sous la forme d'une fente (14) étroite qui s'étend perpendiculairement à l'encoche (15).

9. Procédé selon la revendication 8, **caractérisé en ce que**, pour mettre en forme l'unité corps de base-substrat (11, 12) selon la géométrie souhaitée, on utilise un corps de base de mise en forme (17) autour duquel l'unité corps de base-substrat (11, 12) est fléchie.
